# FASCICULE DE BREVET EUROPEEN

(11) **EP 1 427 099 B1**
(45) Date de publication et mention de la délivrance du brevet: **10.01.2007**
(21) Numéro de dépôt: 03292817.8
(22) Date de dépôt: 13.11.2003
(51) Int. Cl.: H03D 7/14

(54) **Procédé de réduction de la non-linéarité d'ordre deux d'un dispositif de transposition de fréquence et dispositif correspondant**
Verfaren zur Verminderung von Nicht-Linearität zweiter Ordnung in einem Frequenzumsetzer und Vorrichtung
Method for reduction of second order non-linearity in a frequency converter, and device

(30) Priorité: 26.11.2002 FR 0214799
(43) Date de publication de la demande: 09.06.2004
(73) Titulaire: STMicroelectronics S.A., 92120 Montrouge (FR)
(72) Inventeur: Pellat, Bruno, 38660 La Terrasse (FR); Gellida, Sylvie, 38000 Grenoble (FR)
(74) Mandataire: Dossmann, Gérard

(56) Documents cités:
- EP-A- 0 951 138
- EP-A- 1 081 848
- WO-A-02/084859
- DE-C- 19 743 272
- US-A- 5 859 559
- US-A1- 2002 160 740

## Description

L'invention concerne la transposition de fréquence et plus particulièrement la réduction de la non-linéarité d'ordre deux d'un dispositif de transposition de fréquence, ou mélangeur.

L'invention s'applique avantageusement, mais non limitativement, aux systèmes de communication sans fil et plus particulièrement aux téléphones mobiles cellulaires.

Dans un terminal d'un système de communication sans fil, comme par exemple un téléphone mobile cellulaire, la conversion directe, ou transposition à fréquence intermédiaire nulle, est une alternative à une architecture superhétérodyne, et est particulièrement bien adaptée pour permettre des solutions architecturales très fortement intégrées pour ce terminal.

Un récepteur à conversion directe, ou bien un récepteur à fréquence intermédiaire nulle (récepteur zéro-IF) convertit la bande du signal utile directement autour de la fréquence nulle (bande de base) au lieu de la convertir à une fréquence intermédiaire de l'ordre de quelques centaines de MHz.

Ceci étant, les récepteurs radiofréquences à conversion directe présentent un inconvénient qui réside dans la non-linéarité d'ordre 2 des étages d'entrée. En effet, puisqu'après le mélangeur, la bande du signal utile est centrée autour de zéro, tout signal non désiré, continu ou basse fréquence, est donc un signal parasite. Ces signaux parasites peuvent venir en particulier du décalage continu (ou, selon la modulation, des parasites basse fréquence) généré par des signaux bloqueurs d'entrée en raison de la non-linéarité d'ordre 2 des étages amont.

Plus précisément, cette non-linéarité d'ordre 2 peut venir, soit de l'amplificateur faible bruit (LNA) généralement connecté après l'antenne, ou bien du mélangeur.

Cependant, tout signal non désiré basse fréquence présent à la sortie de l'amplificateur faible bruit ne constitue pas, en première approximation, un problème, puisque le mélangeur va le convertir à haute fréquence.

En conséquence, le problème principal vient de la non-linéarité d'ordre 2 du mélangeur lui-même.

La plupart des circuits actuels n'utilisent pas de solution conceptuelle (« design solution ») spécifique pour résoudre le problème de la non-linéarité d'ordre 2 du mélangeur. Ces circuits utilisent généralement des algorithmes destinés à contrôler ces parasites continus. Cependant, de tels algorithmes ne sont pas faciles à développer et, en outre, ils sont inefficaces lorsque les signaux bloqueurs induisent, non pas un signal parasite purement continu, comme c'est le cas dans les systèmes GSM à modulation à enveloppe constante, mais un signal parasite modulé basse fréquence, comme c'est le cas pour les systèmes à modulation à enveloppe non constante, tels que les systèmes WCDMA.

EP 0 951 138 A1 décrit une méthode d'attenuation des signaux parasites dans laquelle on équilibre les opérations de mélange à l'aide de tensions et/ou de courants de polarisation de niveaux variables.

Ceci étant, des solutions conceptuelles ont été proposées pour résoudre ce problème de non-linéarité d'ordre 2 du mélangeur.

Certaines de ces solutions, développées en particulier pour les systèmes à modulation à enveloppe constante, sont basées sur un ajustement en production du décalage continu du mélangeur (DC offset) grâce à une charge de sortie réglable. Une telle solution est par exemple décrite dans l'article de Alyosha Molnar, intitulé « A single Chip Quad Band (850, 900, 1800, 1900 MHz) Direct Conversion GSM/GPRS RF Tranceiver with integrated VCOs and Fractional-N Synthétiser », ISSCC 2002 - session 14.

Un autre type de solution, dénommé « Appariement dynamique », consiste à commuter dynamiquement, c'est-à-dire lors du fonctionnement du mélangeur, les entrées et les sorties, de façon à avoir un comportement moyen symétrique du mélangeur. Une telle solution est par exemple décrite dans l'article de Edwin Bautista, et autres, intitulé « Improved Mixer IIP2 Through Dynamic Matching », ISSCC 2000 - session 23 - Wireless building blocks Paper WP 23.1.

Cependant, si une telle solution est intéressante car elle ne nécessite aucun réglage en production, elle présente néanmoins l'inconvénient de nécessiter une très bonne synchronisation de la commutation des entrées et des sorties, ce qui est particulièrement difficile à obtenir puisque les entrées et les sorties sont éloignées sur le schéma de placement (layout) en raison des problèmes d'isolation. Par ailleurs, une horloge spécifique de commutation est nécessaire avec le risque d'un repliement non désiré dans la bande du signal utile.

L'invention vise à apporter une solution à ce problème de la non-linéarité d'ordre 2 d'un mélangeur, en proposant une solution radicalement différente de celles existant actuellement.

L'invention a pour but de ne nécessiter aucun réglage du mélangeur en production.

L'invention a également pour but de ne nécessiter aucun algorithme spécifique destiné à contrôler les décalages continus induits par les signaux bloqueurs.

L'invention a encore pour but de proposer un mélangeur insensible à des signaux bloqueurs d'entrée modulés, ce qui est particulièrement intéressant pour les récepteurs incorporés dans les téléphones mobiles de troisième génération.

L'invention part de l'observation que la cause de la non-linéarité d'ordre 2 d'un dispositif de transmission de fréquence, ou mélangeur, est due principalement au décalage électrique (« electrical offset ») dans les transistors du circuit de commutation de courant du mélangeur. Aussi, partant de cette observation, l'invention propose d'étalonner ce décalage dans le mélangeur lui-même.

En d'autres termes, l'invention propose un procédé de réduction de la non-linéarité d'ordre deux d'un dispositif de transmission de fréquence, ce dispositif comportant un circuit de commutation de courant à deux paires différentielles de transistors commandables par un signal d'oscillateur local.

Selon une caractéristique générale de l'invention, les deux paires différentielles étant statiquement mutuellement déconnectées et dynamiquement mutuellement connectées au niveau des bases de transistors, le procédé comprend un mode d'étalonnage du circuit de commutation de courant, dans lequel on rend l'oscillateur local inactif et on étalonne successivement chacune des deux paires en annulant le courant de pied de la paire non en cours d'étalonnage, et en ajustant la différence de tension appliquée sur les bases des transistors de la paire en cours d'étalonnage jusqu'à annuler à une précision près la tension de sortie du dispositif de transposition de fréquence, c'est-à-dire généralement la tension de sortie du circuit de commutation de courant.

On mémorise alors la différence de tension de base ainsi obtenue.

Le procédé comporte par ailleurs un mode de fonctionnement normal du mélangeur, dans lequel on rend l'oscillateur local actif et on applique sur les bases des transistors des deux paires les deux différences de tension respectivement mémorisées à l'issue du mode d'étalonnage.

Selon un mode de mise en oeuvre, dans le mode d'étalonnage, la phase d'ajustement de la différence de tension de base comporte une détection du changement de signe de la différence de tension de sortie.

La différence de tension appliquée sur les bases de deux transistors d'une paire, est par exemple fournie par un convertisseur numérique/analogique en réponse à un mot numérique de commande. La phase d'ajustement de la différence de tension de base comporte alors, par exemple, une modification du mot numérique de commande et la mémorisation de la différence de tension de base finalement obtenue à l'issue de l'étalonnage comporte une mémorisation du mot numérique de commande correspondant.

Ainsi, dans un mode de mise en oeuvre de l'invention, on modifiera le mot numérique de commande, par exemple par une décrémentation à partir d'une valeur maximale, jusqu'à la détection du changement de signe de la différence de tension de sortie.

L'invention a également pour objet un dispositif de transposition de fréquence comportant un circuit de commutation de courant à deux paires différentielles de transistors commandable par un signal d'oscillateur local.

Selon une caractéristique générale de l'invention, les deux paires différentielles sont statiquement mutuellement déconnectées et dynamiquement mutuellement connectées au niveau des bases des transistors, et le dispositif comprend une boucle d'étalonnage activable sur commande et apte à étalonner chaque paire différentielle en ajustant la différence de tension appliquée sur les bases des transistors de la paire en cours de étalonnage jusqu'à annuler à une précision près la tension de sortie du dispositif de transposition de fréquence. Des moyens de mémorisation sont aptes à mémoriser pour chaque paire la différence de tension de base obtenue après étalonnage, et des moyens de commande sont aptes
soit à rendre inactif l'oscillateur local et à activer les moyens d'étalonnage en annulant successivement le courant de pied de chaque paire,
soit à rendre actif l'oscillateur local, à désactiver la boucle d'étalonnage et à appliquer sur les bases des transistors des deux paires les deux différences de tension respectivement mémorisées dans les moyens de mémorisation.

Selon un mode de réalisation de l'invention, la boucle d'étalonnage comporte des moyens de détection aptes à détecter le changement de signe de la différence de tension de sortie.

Les moyens de détection peuvent comporter un comparateur dont les deux entrées sont reliées aux deux sorties différentielles du dispositif.

Selon un mode de réalisation de l'invention, la boucle d'étalonnage comporte
- deux convertisseurs numériques/analogiques respectivement connectés sur les bases des transistors des deux paires, chaque convertisseur étant apte à appliquer une différence de tension sur les bases des transistors de la paire correspondante en réponse à un mot numérique de commande, et
- des moyens de contrôle connectés à la sortie des moyens de détection et aptes à élaborer des mots de commande successifs jusqu'à la réception d'un signal d'arrêt délivré par les moyens de détection.

Par ailleurs, chaque convertisseur est préférentiellement apte à délivrer une différence de tension proportionnelle à la température absolue (tension PTAT).

Selon un mode de réalisation de l'invention, les moyens de commande sont aptes à désactiver la boucle d'étalonnage en désactivant les moyens de détection et les moyens de contrôle.

Le dispositif selon l'invention est avantageusement réalisé sous forme intégrée.

L'invention vise également un composant d'un système de communication sans fil, par exemple un téléphone mobile cellulaire, incorporant un dispositif de transposition de fréquence tel que défini ci-avant.

D'autres avantages et caractéristiques de l'invention apparaîtront à l'examen de la description détaillée de modes de réalisation et de mise en oeuvre, nullement limitatifs, et des dessins annexés sur lesquels :
- la figure 1 illustre schématiquement et partiellement l'architecture interne d'un téléphone mobile cellulaire selon l'invention ;
- la figure 2 illustre plus en détail un mode de réalisation d'un dispositif de transposition de fréquence selon l'invention ; et
- les figures 3 à 5 illustrent schématiquement un mode de mise en oeuvre du procédé selon l'invention.

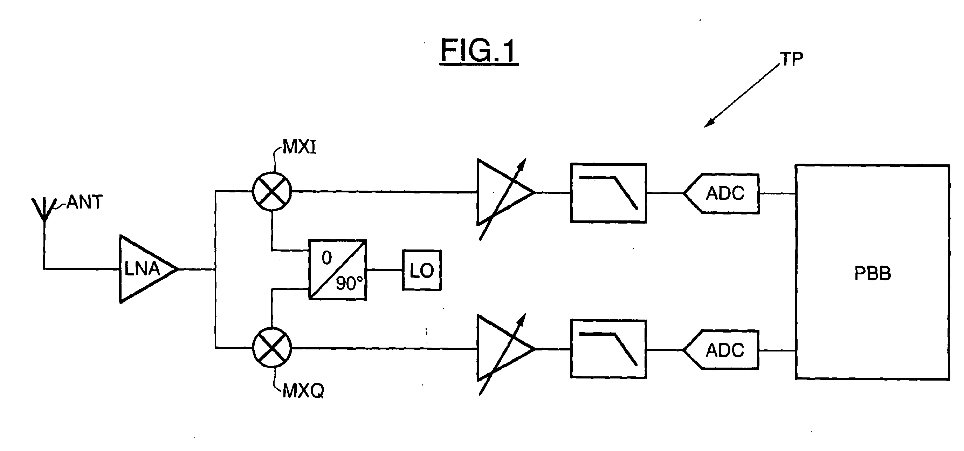

Sur la figure 1, la référence TP désigne un téléphone mobile cellulaire incorporant des dispositifs de transposition de fréquence, ou mélangeurs, MXI ou MXQ, selon l'invention.

Plus précisément, de façon classique, le téléphone mobile comporte un étage radiofréquence connecté à un étage numérique architecturé autour d'un processeur PBB, par l'intermédiaire de convertisseurs analogiques/numériques ADC.

L'étage radiofréquence comporte en tête une antenne ANT suivie essentiellement d'un amplificateur faible bruit LNA connecté à deux mélangeurs MXI et MXQ appartenant de façon classique à deux voies de traitement en quadrature de phase, habituellement dénommées par l'homme du métier « voie I » et « voie Q ».

Chaque mélangeur MXI et MXQ reçoit un signal de transposition de fréquence issu d'un oscillateur local LO. Un déphaseur 0/90°, interposé entre l'oscillateur local et les mélangeurs, permet de délivrer au mélangeur MXQ un signal d'oscillateur local déphasé de 90° par rapport au signal d'oscillateur local délivré au mélangeur MXI.

Chacun des mélangeurs est suivi d'un amplificateur à gain commandé et d'un étage de filtrage passe-bas.

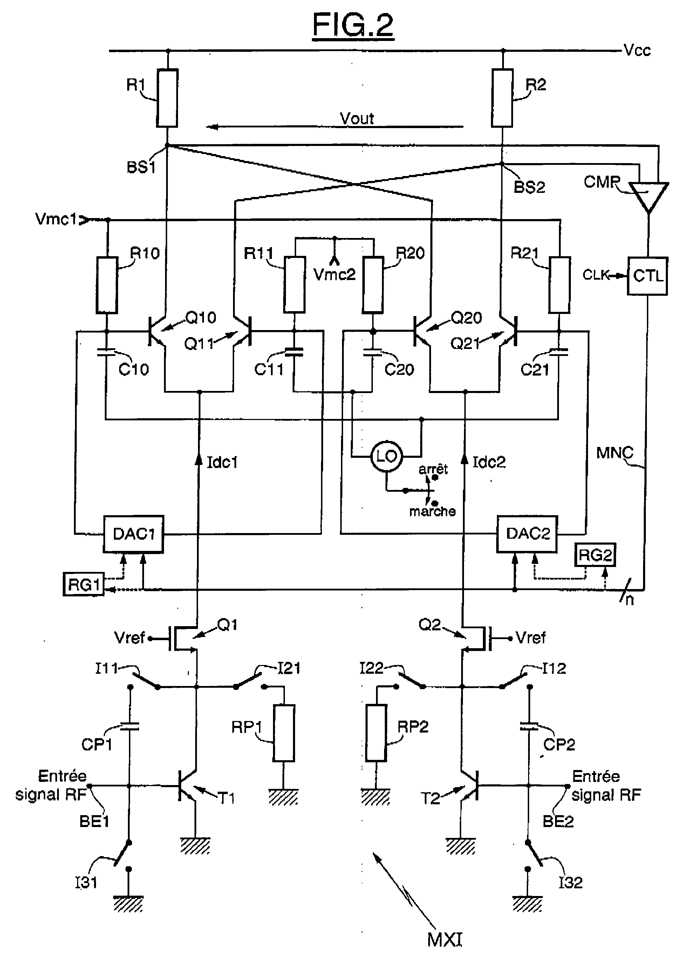

On va maintenant décrire, en se référant plus particulièrement à la figure 2, l'un des mélangeurs, par exemple le mélangeur MXI, étant bien entendu que le deuxième mélangeur MXQ est analogue à celui que l'on va décrire.

Le mélangeur MXI, par exemple de structure différentielle, comporte un circuit de commutation de courant à deux paires différentielles de transistors Q10, Q11, d'une part, et Q20, Q21, d'autre part. Les sorties de ces transistors sont couplées de façon croisée. Plus précisément, le collecteur du transistor Q10 et le collecteur du transistor Q20 sont reliés ensemble pour former une première borne de sortie BS1, tandis que le collecteur du transistor Q11 et le collecteur du transistor Q21 sont reliés ensemble pour former une deuxième borne de sortie BS2. Ces deux bornes de sortie forment la sortie différentielle du mélangeur MXI. Les résistances R1 et R2 représentent les résistances de charge du mélangeur MXI.

Par ailleurs, la base du transistor Q10 et la base du transistor Q21 sont reliées ensemble par deux condensateurs C10 et C21 connectés en série. De même, la base du transistor Q11 et la base du transistor Q20 sont reliées ensemble par deux condensateurs C11 et C20 reliés en série.

Le point milieu des deux condensateurs C10 et C21 ainsi que le point milieu des deux condensateurs C11 et C20 sont respectivement connectés aux deux bornes de la sortie différentielle de l'oscillateur local LO.

Les deux bases des transistors Q11 et Q20 sont par ailleurs reliées ensemble par deux résistances R11 et R20. Il en est de même des bases des transistors Q10 et Q21 qui sont reliées ensemble par l'intermédiaire de deux résistances R10 et R21. Des sources de tension Vmc1 et Vmc2 permettent de contrôler le mode commun.

Ainsi, avec ce montage, les deux paires différentielles sont statiquement mutuellement déconnectées mais dynamiquement mutuellement connectées, c'est-à-dire mutuellement connectées en présence d'un signal radiofréquence à l'entrée différentielle BE1-BE2 du mélangeur MXI.

A cet égard, un bloc transconducteur d'entrée est connecté entre les bornes BE1 et BE2 et les collecteurs des transistors des deux paires différentielles.

Dans l'exemple décrit ici, qui n'est nullement limitatif, ce bloc transconducteur d'entrée comporte deux transistors bipolaires T1 et T2 dont les émetteurs sont reliés à la masse et dont les bases respectives sont reliées aux bornes BE1 et BE2. Ces deux transistors T1 et T2 sont reliés aux collecteurs des transistors Q10-Q11 d'une part, et Q20-Q21 d'autre part, par deux montages cascodes.

Une source de tension Vref, appliquée sur les grilles des transistors Q1 et Q2, fixe le courant statique de pied Idc1 et Idc2 de chacune des deux paires différentielles.

Par ailleurs, dans l'exemple décrit ici, un jeu de deux fois trois interrupteurs I11, I21, I31, et I12, I22 et I32, associés à deux condensateurs CP1 et CP2, ainsi qu'à deux résistances RP1 et RP2, permettent de choisir entre un fonctionnement à faible gain ou à fort gain.

Outre les moyens qui viennent d'être décrits, le mélangeur selon l'invention comporte une boucle d'étalonnage formée ici d'un comparateur CMP dont les deux entrées sont reliées respectivement aux deux bornes de sortie BS1 et BS2. La sortie du comparateur CMP est reliée à des moyens de contrôle CTL cadencés par un signal d'horloge CK et délivrant un mot numérique de commande MNC, ici sur n bits, à deux convertisseurs numériques/analogiques DAC1 et DAC2.

Les sorties différentielles du convertisseur DAC1 sont reliées aux bases des transistors Q10 et Q11 de la première paire différentielle, tandis que les sorties différentielles du convertisseur DAC2 sont reliées aux bases des transistors Q1 et Q21 de la deuxième paire différentielle.

Ainsi, chaque convertisseur est capable d'appliquer une différence de tension sur les bases des transistors correspondants, en fonction du mot de commande qui lui est appliqué (ce mot de commande définissant un code pour le convertisseur).

Par ailleurs, des moyens de commande, par exemple réalisés de façon logicielle au sein du processeur PBB, vont activer ou désactiver la boucle d'étalonnage et l'oscillateur local LO.

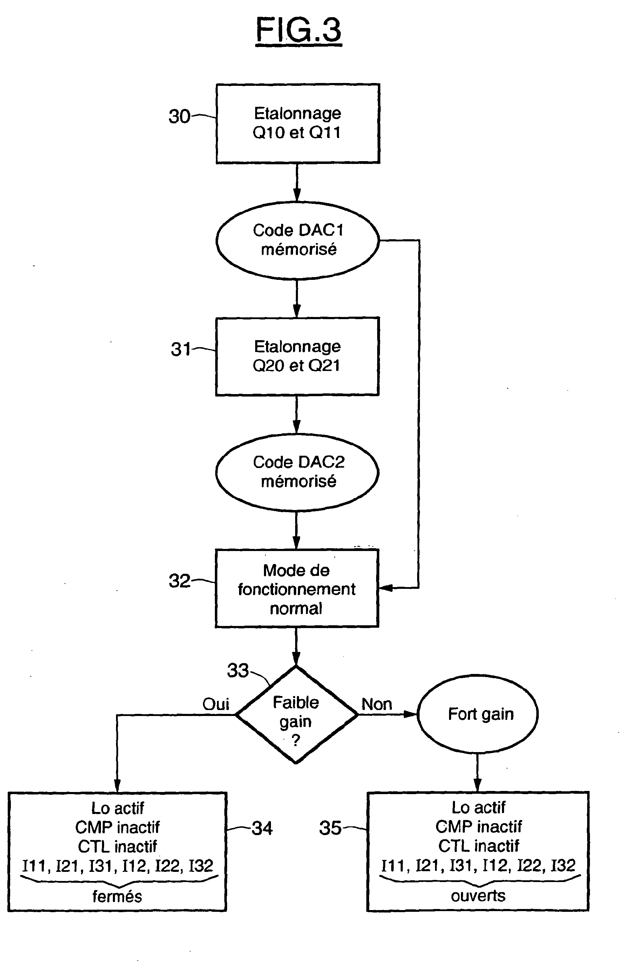

On va maintenant décrire plus en détail, en se référant plus particulièrement aux figures 3 et suivantes, le fonctionnement du mélangeur selon l'invention.

Si l'on considère le comportement statique du mélangeur, et plus particulièrement le comportement statique de chacune des paires différentielles prises indépendamment l'une de l'autre, alors les courants dynamiques de pied sont nuls ainsi que la tension délivrée par l'oscillateur local LO qui est en arrêt. Le courant statique Idc1, de la paire Q10-Q11 par exemple, est en théorie divisé en deux par la paire Q10-Q11. Cependant, en raison du défaut d'appariement des transistors, il existe un décalage de tension (offset) qui se traduit aux bornes BS1 et BS2 par une tension de sortie Vout non nulle et égale à (-1+2α). RIdc1, si l'on suppose R=R1=R2.

Ainsi, la tension de sortie continue Vout est une image du défaut d'appariement α des transistors Q10-Q11. De même, si l'on considère la paire Q20-Q21 prise isolément, cette tension Vout est une image du défaut d'appariement des transistors Q20 et Q21.

La boucle d'étalonnage va alors avoir pour but d'annuler cette tension Vout pour chacune des paires différentielles prises isolément.

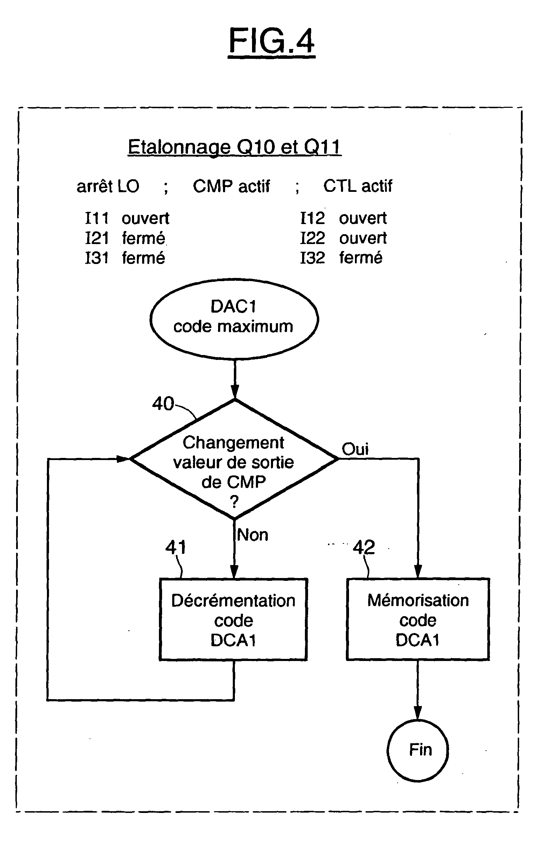

Plus précisément, comme illustré sur la figure 3, on commence par exemple par l'étalonnage 30 de la paire de transistors Q10-Q11. Cet étalonnage est plus particulièrement illustré sur la figure 4.

Pour cet étalonnage, on place l'oscillateur local LO en arrêt, on active le comparateur CMP ainsi que les moyens de contrôle CTL.

Les interrupteurs I11, I12 et I22 sont ouverts et les autres interrupteurs I21, I31 et I32 sont fermés.

Puisqu'on étalonne la paire Q10 et Q11, on annule le courant statique de pied Idc2 de la paire de transistors Q20 et Q21. Ceci est réalisé ici par la configuration des interrupteurs.

Dans l'exemple décrit ici, on confère au convertisseur DAC1 son code maximum, par exemple en plaçant tous les bits du mot de commande à 1.

Puis, on va détecter (étape 40) le changement de la valeur de sortie du comparateur CMP. En effet, tant que la différence de tension Vout est positive, le comparateur CMP délivre la valeur 1 par exemple, tandis que si cette différence de tension est négative, le comparateur CMP délivre la valeur 0.

Le changement de la valeur de sortie du comparateur CMP sera donc caractéristique de l'annulation de la tension Vout à la précision près du convertisseur DAC1.

Ainsi, tant que la valeur de sortie du comparateur CMP n'est pas modifiée, les moyens de contrôle vont décrémenter (étape 41) le mot de commande appliqué au convertisseur DAC1, ce qui va avoir pour conséquence de modifier la différence de tension de base appliquée sur la paire différentielle des transistors Q10 et Q11.

Puis, au changement de valeur de sortie du comparateur CMP, le mot de commande correspondant va être mémorisé (étape 42), par exemple dans un registre RG1.

La phase d'étalonnage de la paire de transistors Q10 et Q11 est alors terminée.

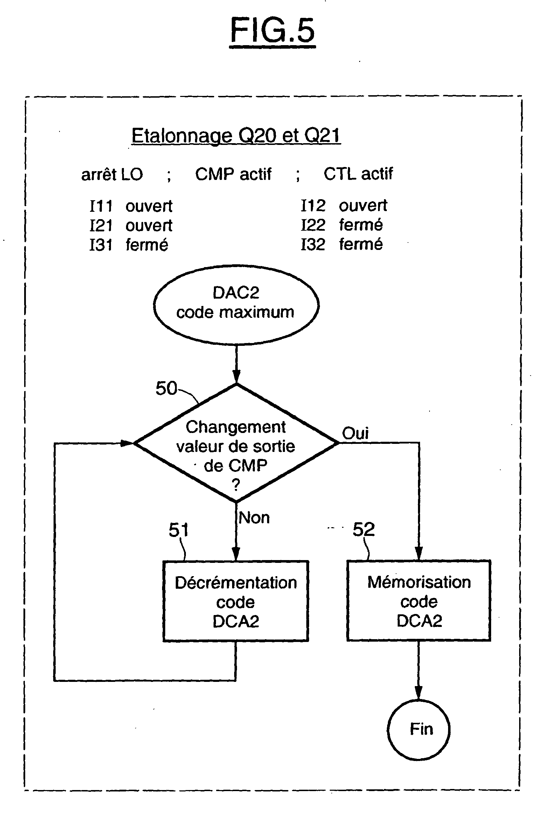

On procède ensuite, comme illustré dans l'étape 31 de la figure 3, à l'étalonnage de la paire de transistors Q20 et Q21. Cet étalonnage est illustré plus en détail sur la figure 5.

Seules les différences avec la figure 4 seront maintenant décrites.

Pour cet étalonnage, l'interrupteur 121 est maintenant ouvert et l'interrupteur 122 fermé.

Et, c'est cette fois-ci le courant statique de pied Idc1 qui est annulé.

Les étapes 50, 51 et 52 sont analogues aux étapes 40, 41 et 42.

Lors de la détection du changement de la valeur de sortie du comparateur CMP, le mot de commande correspondant du convertisseur DAC2 est mémorisé dans un registre RG2, ce qui marque la fin de la phase d'étalonnage de la paire Q20-Q21.

Une fois ce mode d'étalonnage effectué, on passe alors dans un mode de fonctionnement normal (étape 32).

Dans ce mode de fonctionnement normal, les convertisseurs DAC1 et DAC2 sont constamment commandés par les mots de commande obtenus à l'issue du mode d'étalonnage. En conséquence, ils appliquent respectivement sur les paires de transistors correspondants les différences de tension de base permettant de corriger de façon électrique les défauts d'appariement des transistors du circuit de commutation de courant.

Dans ce mode de fonctionnement normal, l'oscillateur local LO est actif, c'est-à-dire qu'il est en marche. Par contre, le comparateur CMP est inactif, de même que les moyens de contrôle CTL (horloge CK coupée).

On peut alors choisir dans ce mode de fonctionnement normal un mode faible gain (étape 34), dans lequel tous les interrupteurs I11, I21, I31, I12, I22 et I32 sont fermés, ou bien un mode fort gain, dans lequel tous les interrupteurs précités sont ouverts.

L'étalonnage s'effectuera, dans le cas d'un téléphone mobile cellulaire, de préférence à la mise en marche du téléphone, et, à des instants ultérieurs qui pourront être définis par le processeur en bande de base PBB. Ceci permettra notamment de tenir compte de l'évolution de la température qui est un paramètre qui influe sur le défaut d'appariement. A cet égard, il sera avantageux de prévoir des convertisseurs DAC1 et DAC2 incorporant une source de tension proportionnelle à la température absolue (source PTAT).

## Revendications

1. Procédé de réduction de la non-linéarité d'ordre deux d'un dispositif de transposition de fréquence comportant un circuit de commutation de courant à deux paires différentielles de transistors (Q10, Q11, Q20, Q21) commandables par un signal d'oscillateur local (LO), **caractérisé par le fait que**, les deux paires différentielles étant statiquement mutuellement déconnectées et dynamiquement mutuellement connectées au niveau des bases des transistors, il comprend
une étape d'étalonnage du circuit de commutation de courant, dans laquelle on rend l'oscillateur local (LO) inactif et on étalonne successivement chacune des deux paires en annulant le courant de pied (Idc2) de la paire (Q20, Q21) non en cours d'étalonnage et en ajustant la différence de tension appliquée sur les bases des transistors de la paire (Q10, Q11) en cours d'étalonnage jusqu'à annuler à une précision près la tension de sortie (Vout) du dispositif de transposition de fréquence, et on mémorise la différence de tension de base ainsi obtenue et
une étape de fonctionnement dans laquelle on rend l'oscillateur local (LO) actif et on applique sur les bases des transistors des deux paires les deux différences de tension respectivement mémorisées à l'issue du mode d'étalonnage.

2. Procédé selon la revendication 1, **caractérisé par le fait que** dans l'étape d'étalonnage la phase d'ajustement de la différence de tension de base comporte une détection (CMP) du changement de signe de la différence de tension de sortie (Vout).

3. Procédé selon la revendication 1 ou 2, **caractérisé**
**par le fait que** la différence de tension appliquée sur les bases des deux transistors d'une paire est fournie par un convertisseur numérique analogique (DAC1, DAC2) en réponse à un mot numérique de commande,
**par le fait que** la phase d'ajustement de la différence de tension de base comporte une modification du mot numérique de commande,
et **par le fait que** la mémorisation de la différence de tension de base finalement obtenue à l'issue de l'étalonnage comporte une mémorisation du mot numérique de commande correspondant.

4. Procédé selon les revendications 2 et 3, **caractérisé par le fait qu'**on modifie le mot numérique de commande (MNC) jusqu'à la détection du changement de signe de la différence de tension de sortie.

5. Dispositif de transposition de fréquence comportant un circuit de commutation de courant à deux paires différentielles de transistors commandables par un signal d'oscillateur local, **caractérisé**
**par le fait que** les deux paires différentielles (Q10, Q11, Q20, Q21) sont statiquement mutuellement déconnectées et dynamiquement mutuellement connectées au niveau des bases des transistors,
**par le fait qu'**il comprend une boucle d'étalonnage activable sur commande et apte étalonner chaque paire différentielle en ajustant la différence de tension appliquée sur les bases des transistors de la paire en cours de étalonnage jusqu'à annuler à une précision près la tension de sortie du dispositif de transposition de fréquence, des moyens de mémorisation (RG1, RG2) aptes à mémoriser pour chaque paire la différence de tension de base obtenue après étalonnage, des moyens de commande (PBB) aptes soit à rendre inactif l'oscillateur local et à activer les moyens d'étalonnage en annulant successivement le courant de pied de chaque paire, soit à rendre actif l'oscillateur local, à désactiver la boucle d'étalonnage et à appliquer sur les bases des transistors des deux paires les deux différences de tension respectivement mémorisées dans les moyens de mémorisation.

6. Dispositif selon la revendication 5, **caractérisé par le fait que** la boucle d'étalonnage comporte des moyens de détection (CMP) aptes à détecter le changement de signe de la différence de tension de sortie.

7. Dispositif selon la revendication 6, **caractérisé par le fait que** les moyens de détection comportent un comparateur (CMP) dont les deux entrées sont reliées aux deux sorties différentielles du dispositif.

8. Dispositif selon la revendication 6 ou 7, **caractérisé par le fait que** la boucle d'étalonnage comporte deux convertisseurs numériques/analogiques (DAC1, DAC2) respectivement connectés sur les bases des transistors des deux paires, chaque convertisseur étant apte à appliquer une différence de tension sur les bases des transistors de la paire correspondante en réponse à un mot numérique de commande, et des moyens de contrôle (CTL) connectés à la sortie des moyens de détection et aptes à élaborer des mots de commande successifs jusqu'à la réception d'un signal d'arrêt délivré par les moyens de détection.

9. Dispositif selon la revendication 8, **caractérisé par le fait que** chaque convertisseur (DAC1, DAC2) est apte à délivrer une différence de tension proportionnelle à la température absolue.

10. Dispositif selon la revendication 8 ou 9, **caractérisé par le fait que** les moyens de commande (PBB) sont aptes à désactiver la boucle d'étalonnage en désactivant les moyens de détection et les moyens de contrôle.

11. Dispositif selon l'une des revendications 5 à 10, **caractérisé par le fait que** les bases des deux transistors homologues de chaque paire sont reliées par l'intermédiaire de deux condensateurs connectés en série, et **par le fait que** le point milieu des deux condensateurs est connecté à l'oscillateur local.

12. Dispositif selon l'une des revendications 5 à 11, **caractérisé par le fait qu'**il réalisé sous forme intégrée.

13. Composant d'un système de communication sans fil, **caractérisé par le fait qu'**il incorpore un dispositif de transposition de fréquence selon l'une des revendications 5 à 12.

14. Composant selon la revendication 13, **caractérisé par le fait qu'**il forme un téléphone mobile cellulaire.

## Claims

1. Method for reducing the second-order nonlinearity of a frequency transposition device comprising a current switching circuit with two differential pairs of transistors (Q10, Q11, Q20, Q21) controllable by a local oscillator signal (LO), **characterized in that**, the two differential pairs being statically mutually disconnected and dynamically mutually connected at the level of the bases of the transistors, it comprises a current switching circuit calibration step, in which the local oscillator (LO) is rendered inactive and each of the two pairs is calibrated in succession by zeroing the earth path current (Idc2) of the pair (Q20, Q21) not undergoing calibration and by setting the voltage difference applied to the bases of the transistors of the pair (Q10, Q11) undergoing calibration until the output voltage (Vout) of the frequency transposition device is zeroed to within some accuracy, and the base voltage difference thus obtained is stored, and
a normal operating step in which the local oscillator (LO) is rendered active and the two voltage differences stored respectively on completion of the calibration mode are applied to the bases of the transistors of the two pairs.

2. Method according to Claim 1, **characterized in that** in the calibration step the phase of setting of the base voltage difference comprises a detection (CMP) of the changing of sign of the difference in output voltage (Vout).

3. Method according to Claim 1 or 2, **characterized in that** the voltage difference applied to the bases of the two transistors of a pair is provided by a digital analogue converter (DAC1, DAC2) in response to a digital control word,
**in that** the phase of setting of the base voltage difference comprises a modifying of the digital control word,
and **in that** the storing of the base voltage difference finally obtained on completion of the calibration comprises a storing of the corresponding digital control word.

4. Method according to Claim 2 and 3, **characterized in that** the digital control word (MNC) is modified until the changing of sign of the output voltage difference is detected.

5. Frequency transposition device comprising a current switching circuit with two differential pairs of transistors controllable by a local oscillator signal, **characterized**
**in that** the two differential pairs (Q10, Q11, Q20, Q21) are statically mutually disconnected and dynamically mutually connected at the level of the bases of the transistors,
**in that** it comprises a calibration loop activatable on command and able to calibrate each differential pair by setting the voltage difference applied to the bases of the transistors of the pair undergoing calibration until the output voltage of the frequency transposition device is zeroed to within some accuracy, storage means (RG1, RG2) able to store for each pair the base voltage difference obtained after calibration, control means (PBB) able either to render the local oscillator inactive and to activate the calibration means by zeroing the earth path current of each pair in succession, or to render the local oscillator active, to deactivate the calibration loop and to apply the two voltage differences stored respectively in the storage means to the bases of the transistors of the two pairs.

6. Device according to Claim 5, **characterized in that** the calibration loop comprises detection means (CMP) able to detect the changing of sign of the output voltage difference.

7. Device according to Claim 6, **characterized in that** the detection means comprise a comparator (CMP) whose two inputs are linked to the two differential outputs of the device.

8. Device according to Claim 6 or 7, **characterized in that** the calibration loop comprises two digital/analogue converters (DAC1, DAC2) respectively connected to the bases of the transistors of the two pairs, each converter being able to apply a voltage difference to the bases of the transistors of the corresponding pair in response to a digital control word, and monitoring means (CTL) connected to the output of the detection means and able to formulate successive control words until a stop signal delivered by the detection means is received.

9. Device according to Claim 8, **characterized in that** each converter (DAC1, DAC2) is able to deliver a voltage difference proportional to the absolute temperature.

10. Device according to Claim 8 or 9, **characterized in that** the control means (PBB) are able to deactivate the calibration loop by deactivating the detection means and the monitoring means.

11. Device according to one of Claim 5 or 10, **characterized in that** the bases of the two homologous transistors of each pair are linked by way of two capacitors connected in series, and **in that** the midpoint of the two capacitors is connected to the local oscillator.

12. Device according to Claim 5 or 11, **characterized in that** it is embodied in integrated form.

13. Component of a wireless communication system, **characterized in that** it incorporates a frequency transposition device according to any one of claims 5 to 12.

14. Component according to Claim 13, **characterized in that** it forms a cellular mobile phone.

## Patentansprüche

1. Verfahren zur Verminderung der Nicht-Linearität zweiter Ordnung in einer Frequenzumsetzungsvorrichtung, die eine Stromwenderschaltung mit zwei Differenzpaaren von Transistoren (Q10, Q11, Q20, Q21) aufweist, die von einem Signal eines lokalen Oszillators (LO) gesteuert werden,
**dadurch gekennzeichnet, daß** die zwei Differenzpaare statisch voneinander getrennt sind und dynamisch an den Basen der Transistoren miteinander verbunden sind,
wobei das Verfahren aufweist:
einen Schritt des Eichens der Stromwenderschaltung, in welchem der lokale Oszillator (LO) inaktiviert wird und nacheinander jedes der zwei Paare geeicht wird, indem der Basisstrom (Idc2) des nicht in der Eichung befindlichen Paares (Q20, Q21) annulliert wird und die Spannungsdifferenz, die an den Basen der Transistoren des in der Eichung befindlichen Paars (Q10, Q11) anliegt, angepaßt wird, bis die Ausgangsspannung (Vout) der Frequenzumsetzungsvorrichtung, abgesehen von einer Toleranz, annulliert ist, und die so gewonnene Basisspannungsdifferenz gespeichert wird, und
einen Schritt des normalen Betriebs, in welchem der lokale Oszillator (LO) aktiviert wird und an den Basen der Transistoren der zwei Paare die zwei Spannungsdifferenzen, die jeweils nach Abschluß des Eichschritts gespeichert wurden, angelegt werden.

2. Verfahren nach Anspruch 1, **dadurch gekennzeichnet, daß** in dem Eichschritt die Phase der Anpassung der Basisspannungsdifferenz eine Detektion (CMP) der Vorzeichenänderung der Ausgangsspannungsdifferenz (Vout) aufweist.

3. Verfahren nach Anspruch 1 oder 2, **dadurch gekennzeichnet, daß**
die an den Basen der zwei Transistoren eines Paars anliegende Spannungsdifferenz von einem Digital/Analog-Wandler (DAC1, DAC2) als Antwort auf ein digitales Steuerwort bereitgestellt wird,
**dadurch**, daß die Phase der Anpassung der Basisspannungsdifferenz eine Modifikation des digitalen Steuerworts aufweist, und
**dadurch**, daß die Speicherung der nach Abschluß der Eichung endgültig gewonnenen Basisspannungsdifferenz eine Speicherung des entsprechenden digitalen Steuerworts aufweist.

4. Verfahren nach den Ansprüchen 2 und 3, **dadurch gekennzeichnet, daß** bis zur Detektion der Vorzeichenänderung der Ausgangsspannungsdifferenz das digitale Steuerwort (MNC) modifiziert wird.

5. Frequenzumsetzungsvorrichtung mit einer Stromwenderschaltung mit zwei Differenzpaaren von Transistoren, die von einem Signal eines lokalen Oszillators gesteuert werden, **dadurch gekennzeichnet, daß**
die zwei Differenzpaare (Q10, Q11, Q20, Q21) statisch voneinander getrennt und dynamisch an den Basen der Transistoren miteinander verbunden sind,
**dadurch**, daß die Vorrichtung aufweist:
eine Eichschleife, die auf Befehl aktivierbar ist und in der Lage ist, jedes Differenzpaar zu eichen, indem die Spannungsdifferenz, die an den Basen der Transistoren des in der Eichung befindlichen Paars anliegt, angepaßt wird, bis die Ausgangsspannung der Frequenzumsetzungsvorrichtung, abgesehen von einer Toleranz, annulliert ist,
Speichereinrichtungen (RG1, RG2), die in der Lage sind, für jedes Paar die nach der Eichung gewonnene Basisspannungsdifferenz zu speichern,
Steuereinrichtungen (PBB), die in der Lage sind,
sei es den lokalen Oszillator zu inaktivieren und durch aufeinanderfolgendes Annullieren des Basisstroms jedes Paars die Eicheinrichtungen zu aktivieren,
sei es den lokalen Oszillator zu aktivieren, die Eichschleife zu deaktivieren und an die Basen der Transistoren der zwei Paare die zwei Spannungsdifferenzen anzulegen, die jeweils in den Speichereinrichtungen gespeichert sind.

6. Vorrichtung nach Anspruch 5, **dadurch gekennzeichnet, daß** die Eichschleife Detektionseinrichtungen (CMP) aufweist, die in der Lage sind, die Vorzeichenänderung der Ausgangsspannungsdifferenz zu detektieren.

7. Vorrichtung nach Anspruch 6, **dadurch gekennzeichnet, daß** die Detektionseinrichtungen einen Komparator (CMP) aufweisen, dessen zwei Eingänge mit den zwei Differenzausgängen der Vorrichtung verbunden sind.

8. Vorrichtung nach Anspruch 6 oder 7, **dadurch gekennzeichnet, daß** die Eichschleife aufweist:
zwei Digital/Analog-Wandler (DAC1, DAC2), die jeweils mit den Basen der Transistoren der zwei Paare verbunden sind, wobei jeder Wandler in der Lage ist, als Antwort auf ein digitales Steuerwort eine Spannungsdifferenz an die Basen der Transistoren des entsprechenden Paars anzulegen, und
Steuereinrichtungen (CTL), die mit dem Ausgang der Detektionseinrichtungen verbunden sind und in der Lage sind, bis zum Empfang eines von den Detektionseinrichtungen ausgegebenen Stoppsignals aufeinanderfolgende Steuerwörter auszuarbeiten.

9. Vorrichtung nach Anspruch 8, **dadurch gekennzeichnet, daß** jeder Wandler (DAC1, DAC2) in der Lage ist, eine zur absoluten Temperatur proportionale Spannungsdifferenz auszugeben.

10. Vorrichtung nach Anspruch 8 oder 9, **dadurch gekennzeichnet, daß** die Steuereinrichtungen (PBB) in der Lage sind, durch Deaktivieren der Detektionseinrichtungen und der Steuereinrichtungen die Eichschleife zu deaktivieren.

11. Vorrichtung nach einem der Ansprüche 5 bis 10, **dadurch gekennzeichnet, daß** die Basen der zwei homologen Transistoren jedes Paars über zwei in Serienschaltung verbundene Kondensatoren miteinander verbunden sind und **dadurch**, daß der Mittelpunkt der zwei Kondensatoren mit dem lokalen Oszillator verbunden ist.

12. Vorrichtung nach einem der Ansprüche 5 bis 11, **dadurch gekennzeichnet, daß** sie in Form einer integrierten Schaltung realisiert ist.

13. Bauteil eines drahtlosen Kommunikationssystem, **dadurch gekennzeichnet, daß** es eine Frequenzumsetzungsvorrichtung nach einem der Ansprüche 5 bis 12 aufweist.

14. Bauteil nach Anspruch 13, **dadurch gekennzeichnet, daß** es ein zellulares Mobiltelefon bildet.
